# EUROPEAN PATENT SPECIFICATION

(11) **EP 1 567 913 B1**
(45) Date of publication and mention of the grant of the patent: **29.07.2009**
(21) Application number: 03768879.3
(22) Date of filing: 12.11.2003
(51) Int. Cl.: H01L 21/68, B25B 11/00

(54) **A CHUCKING SYSTEM AND METHOD FOR MODULATING SHAPES OF SUBSTRATES**
EIN HALTERUNGSSYSTEM UND EIN VERFAHREN ZUM MODULIEREN VON SUBSTRATFORMEN
SYSTEME DE COCHET ET PROCEDE DE MODULATION DES FORMES DE SUBSTRATS

(30) Priority: 13.11.2002 US 293224; 11.12.2002 US 316963
(43) Date of publication of application: 31.08.2005
(73) Proprietor: MOLECULAR IMPRINTS, INC., Austin, TX 78758-3605 (US)
(72) Inventor: CHOI, Byung-Jin, Round Rock, TX 787664-8620 (US); VOISIN, Ronald, D., Austin, TX 78759-5843 (US); SREENIVASAN, Sidlgata, V., Austin, TX 78750-3858 (US); WATTS, Michael, P., C., Austin, TX 78730-2709 (US); BABBS, Daniel, A., Austin, TX 78746-7808 (US); MEISSL, Mario, J., A-78752-2344 Austin (AT); BAILEY, Hillman, L., Dripping Springs, TX 78620-2722 (US); SCHUMAKER, Norman, E., Austin, TX 78735-1515 (US)
(74) Representative: Sutto, Luca
(86) International application number: PCT/US2003/036012
(87) International publication number: WO 2004/044651

(56) References cited:
- EP-A- 0 706 210
- US-A- 5 534 073
- US-A- 6 032 997
- US-A- 6 137 562
- US-A1- 2003 092 261
- US-A1- 2003 179 354

## Description

The field of invention relates generally to imprint lithography. More particularly, the present invention is directed to reducing undesirable pattern variations during imprint lithography processes.

Micro-fabrication involves the fabrication of very small structures, e.g., having features on the order of micro-meters or smaller. One area in which micro-fabrication has had a sizeable impact is in the processing of integrated circuits. As the semiconductor processing industry continues to strive for larger production yields while increasing the circuits per unit area formed on a substrate, micro-fabrication becomes increasingly important. Micro-fabrication provides greater process control while allowing increased reduction of the minimum feature dimension of the structures formed. Other areas of development in which micro-fabrication has been employed include biotechnology, optical technology, mechanical systems and the like.

An exemplary micro-fabrication technique is shown in United States patent number 6,334,960 to Willson et al. Willson et al. disclose a method of forming a relief image in a structure. The method includes providing a substrate having a transfer layer. The transfer layer is covered with a polymerizable fluid composition. A mold makes mechanical contact with the polymerizable fluid. The mold includes a relief structure, and the polymerizable fluid composition fills the relief structure. The polymerizable fluid composition is then subjected to conditions to solidify and polymerize the same, forming a solidified polymeric material on the transfer layer that contains a relief structure complimentary to that of the mold. The mold is then separated from the solid polymeric material such that a replica of the relief structure in the mold is formed in the solidified polymeric material. The transfer layer and the solidified polymeric material are subjected to an environment to selectively etch the transfer layer relative to the solidified polymeric material such that a relief image is formed in the transfer layer. The time required and the minimum feature dimension provided by this technique is dependent upon, inter alia, the composition of the polymerizable material.

United States patent number 5,772,905 to Chou discloses a lithographic method and apparatus for creating ultra-fine (sub-36 nm) patterns in a thin film coated on a substrate in which a mold having at least one protruding feature is pressed into a thin film carried on a substrate. The protruding feature in the mold creates a recess in the thin film. The mold is removed from the film. The thin film then is processed such that the thin film in the recess is removed exposing the underlying substrate. Thus, patterns in the mold are replaced in the thin film, completing the lithography. The patterns in the thin film will be, in subsequent processes, reproduced in the substrate or in another material which is added onto the substrate.

Yet another imprint lithography technique is disclosed by Chou et al. in Ultrafast and Direct Imprint of Nanostructures in Silicon, Nature, Col. 417, pp. 835-837, June 2002, which is referred to as a laser assisted direct imprinting (LADI) process. In this process a region of a substrate is made flowable, e.g., liquefied, by heating the region with the laser. After the region has reached a desired viscosity, a mold, having a pattern thereon, is placed in contact with the region. The flowable region conforms to the profile of the pattern and is then cooled, solidifying the pattern into the substrate. An important consideration when forming patterns in this manner is to maintain control of the mold. In this fashion, undesirable variations in the pattern resulting from, *inter* alia, undesired deformation of the mold may be avoided. For example, in-plane distortion can cause line width variations, as well as pattern placement errors. Out-of-plane distortion can cause loss of focus in optical lithography resulting in varying the thickness of underlying residual layers. This may make difficult both line width control and etch transfer. Documents US 6 032 997 and US5 534 073 show chucks with multiple recesses and corresponding suction lines. Document EP0 706 210 shows a chuck having a plurality of suction channels leading to very small holes on an operating chuck surface.

It is desired, therefore, to provide improved techniques for shaping and holding the mold so as to properly position the same with respect to the substrate upon which a pattern is to be formed.

### SUMMARY OF THE INVENTION

The present invention is directed to a chucking system and to a method to modulate substrates according to claims 1 and 8. Specifically, the pressure is established in the first chamber to maintain the position of the substrate with the chuck body. The pressure in the second chamber may differ from the pressure in the first chamber to, inter alia, reduce distortions in the substrate that occur during imprinting. For example, the first chamber may be evacuated to hold the substrate against the chuck body so that separation of the substrate from the chuck body under force of gravity is prevented. The second chamber is pressurized to reduce distortions in a portion of the second side in superimposition therewith. In this manner, hydrostatic pressurization is employed to hold the substrate against the chuck and to compensate for external forces applied to the substrate so as to prevent structural distortions in the substrate. These and other embodiments of the present invention are discussed more fully below. To that end, a method for modulating shapes of a substrate, having first and second opposed surfaces, includes creating a pressure differential between differing regions of the first opposed surface to attenuate structural distortions in the second opposed surface. These and other embodiments of the present invention are discussed more fully below.

### BRIEF DESCRIPTION OF THE DRAWINGS

Fig. 1 is a perspective view of a lithographic system in accordance with the present invention;

Fig. 2 is a simplified elevation view of a lithographic system shown in Fig. 1;

Fig. 3 is a simplified representation of material from which an imprinting layer, shown in Fig. 2, is comprised before being polymerized and cross-linked;

Fig. 4 is a simplified representation of cross-linked polymer material into which the material shown in Fig. 3 is transformed after being subjected to radiation;

Fig. 5 is a simplified elevation view of a mold spaced-apart from the imprinting layer, shown in Fig. 1, after patterning of the imprinting layer;

Fig. 6 is a simplified elevation view of an additional imprinting layer positioned atop of the substrate shown in Fig. 5, after the pattern in the first imprinting layer is transferred therein;

Fig. 7 is a detailed perspective view of a print head shown in Fig. 1;

Fig. 8 is a cross-sectional view of a chucking system in accordance with the present invention;

Fig. 9 is an exploded view of an imprint head shown in Fig. 7;

Fig. 10 is a bottom-up plan view of a chuck body shown in Fig. 8;

Fig. 11 is a top down view of a wafer, shown in Figs. 2, 5 and 6 upon which imprinting layers are disposed;

Fig. 12 is a detailed view of Fig. 11 showing the position of the mold in one of the imprint regions;

Fig. 13 is a bottom-up plan view of the chuck body shown in Fig. 8 in accordance with an alternate embodiment;

Fig. 14 is a cross-sectional view of a chuck body shown in Fig. 8 in accordance with a second alternate embodiment;

Fig. 15 is a flow diagram showing a method of reducing distortions in patterns formed using imprint lithography techniques in accordance with the present invention; and

Fig. 16 is a flow diagram showing a method of reducing distortions in patterns formed using imprint lithography techniques in accordance with an alternate embodiment of the present invention.

### DETAILED DESCRIPTION OF THE INVENTION

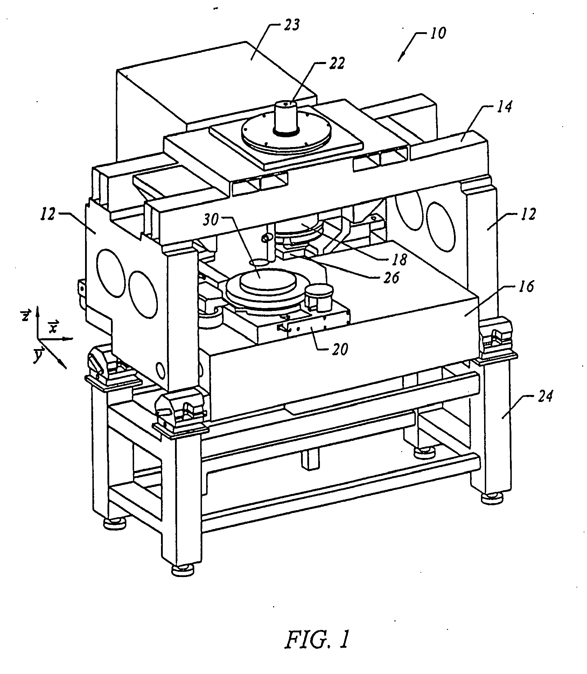

Fig. 1 depicts a lithographic system 10 in accordance with one embodiment of the present invention that includes a pair of spaced-apart bridge supports 12 having a bridge 14 and a stage support 16 extending therebetween. Bridge 14 and stage support 16 are spaced-apart. Coupled to bridge 14 is an imprint head 18, which extends from bridge 14 toward stage support 16. Disposed upon stage support 16 to face imprint head 18 is a motion stage 20. Motion stage 20 is configured to move with respect to stage support 16 along X and Y axes. A radiation source 22 is coupled to system 10 to impinge actinic radiation upon motion stage 20. As shown, radiation source 22 is coupled to bridge 14 and includes a power generator 23 connected to radiation source 22.

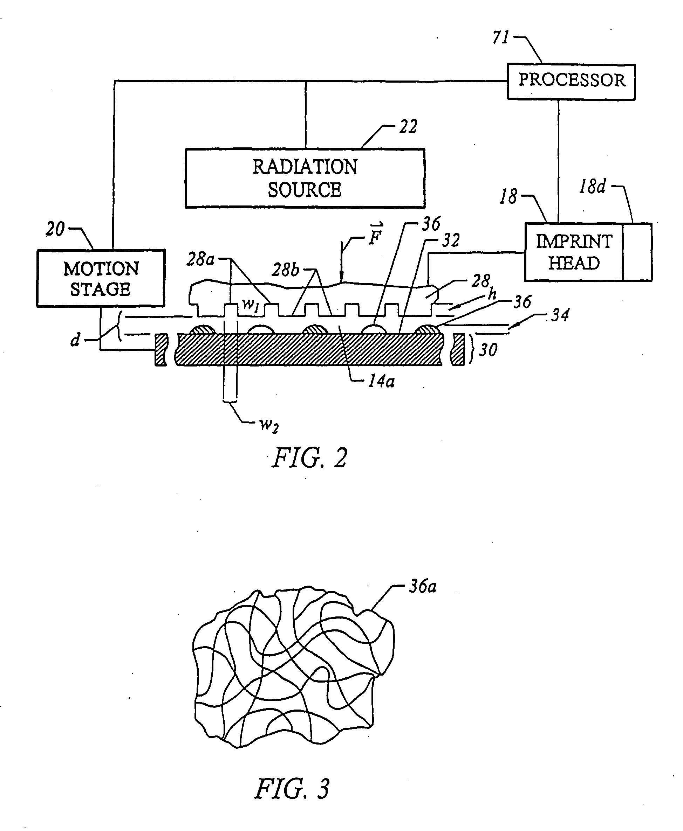

Referring to both Figs. 1 and 2, connected to imprint head 18 is a substrate 26 having a mold 28 thereon. Mold 28 includes a plurality of features defined by a plurality of spaced-apart recessions 28a and protrusions 28b, having a step height, h, on the order of nanometers, e.g., 100 nanometers. The plurality of features defines an original pattern that is to be transferred into a wafer 30 positioned on motion stage 20. To that end, imprint head 18 is adapted to move along the Z axis and vary a distance "d" between mold 28 and wafer 30. In this manner, the features on mold 28 many be imprinted into a flowable region of wafer 30, discussed more fully below. Radiation source 22 is located so that mold 28 is positioned between radiation source 22 and wafer 30. As a result, mold 28 is fabricated from material that allows it to be substantially transparent to the radiation produced by radiation source 22.

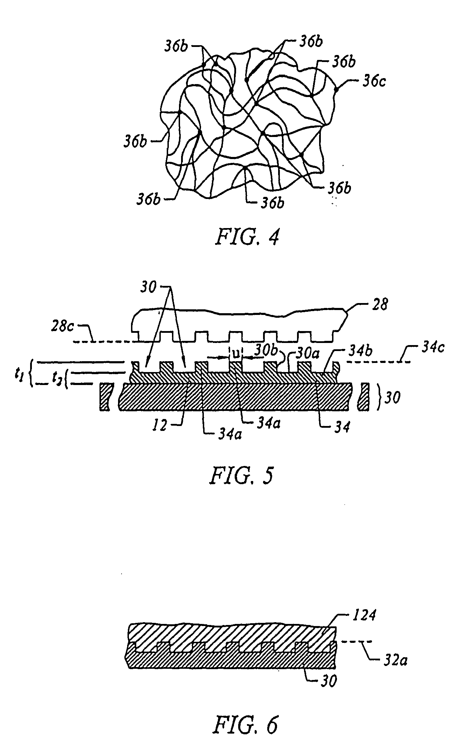

Referring to both Figs. 2 and 3, a flowable region, such as an imprinting layer 34, is disposed on a portion of surface 32 that presents a substantially planar profile. Flowable region may be formed using any known technique such as a hot embossing process disclosed in United States patent number 5,772,905, which is incorporated by reference in its entirety herein, or a laser assisted direct imprinting (LADI) process of the type described by Chou et al. in Ultrafast and Direct Imprint of Nanostructures in Silicon, Nature, Col. 417, pp. 835-837, June 2002. In the present embodiment, however, flowable region consists of imprinting layer 34 being deposited as a plurality of spaced-apart discrete beads 36 of material 36a on wafer 30, discussed more fully below. Imprinting layer 34 is formed from a material 36a that may be selectively polymerized and cross-linked to record the original pattern therein, defining a recorded pattern. Material 36a is shown in Fig. 4 as being cross-linked at points 36b, forming cross-linked polymer material 36c.

Referring to Figs. 2, 3 and 5, the pattern recorded in imprinting layer 34 is produced, in part, by mechanical contact with mold 28. To that end, imprint head 18 reduces the distance "d" to allow imprinting layer 34 to come into mechanical contact with mold 28, spreading beads 36 so as to form imprinting layer 34 with a contiguous formation of material 36a over surface 32. In one embodiment, distance "d" is reduced to allow sub-portions 34a of imprinting layer 34 to ingress into and fill recessions 28a.

To facilitate filling of recessions 28a, material 36a is provided with the requisite properties to completely fill recessions 28a while covering surface 32 with a contiguous formation of material 36a. In the present embodiment, sub-portions 34b of imprinting layer 34 in superimposition with protrusions 28b remain after the desired, usually minimum distance "d", has been reached, leaving sub-portions 34a with a thickness t₁, and sub-portions 34b with a thickness, t₂. Thicknesses "t₁" and "t₂" may be any thickness desired, dependent upon the application. Typically, t₁ is selected so as to be no greater than twice the width u of sub-portions 34a, i.e., t₁ ≤ 2u, shown more clearly in Fig. 5.

Referring to Figs. 2, 3 and 4, after a desired distance "d" has been reached, radiation source 22 produces actinic radiation that polymerizes and crosslinks material 36a, forming cross-linked polymer material 36c. As a result, the composition of imprinting layer 34 transforms from material 36a to material 36c, which is a solid. Specifically, material 36c is solidified to provide side 34c of imprinting layer 34 with a shape conforming to a shape of a surface 28c of mold 28, shown more clearly in Fig. 5. After imprinting layer 34 is transformed to consist of material 36c, shown in Fig. 4, imprint head 18, shown in Fig. 2, is moved to increase distance "d" so that mold 28 and imprinting layer 34 are spaced-apart.

Referring to Fig. 5, additional processing may be employed to complete the patterning of wafer 30. For example, wafer 30 and imprinting layer 34 may be etched to transfer the pattern of imprinting layer 34 into wafer 30, providing a patterned surface 32a, shown in Fig. 6. To facilitate etching, the material from which imprinting layer 34 is formed may be varied to define a relative etch rate with respect to wafer 30, as desired. The relative etch rate of imprinting layer 34 to wafer 30 may be in a range of about 1.5:1 to about 100:1. Alternatively, or in addition to, imprinting layer 34 may be provided with an etch differential with respect to photo-resist material (not shown) selectively disposed thereon. The photo-resist material (not shown) may be provided to further pattern imprinting layer 34, using known techniques. Any etch process may be employed, dependent upon the etch rate desired and the underlying constituents that form wafer 30 and imprinting layer 34. Exemplary etch processes may include plasma etching, reactive ion etching, chemical wet etching and the like.

Referring to both Figs. 1 and 2, an exemplary radiation source 22 may produce ultraviolet radiation. Other radiation sources may be employed, such as thermal, electromagnetic and the like. The selection of radiation employed to initiate the polymerization of the material in imprinting layer 34 is known to one skilled in the art and typically depends on the specific application which is desired. Furthermore, the plurality of features on mold.28 are shown as recessions 28a extending along a direction parallel to protrusions 28b that provide a cross-section of mold 28 with a shape of a battlement. However, recessions 28a and protrusions 28b may correspond to virtually any feature required to create an integrated circuit and may be as small as a few tenths of nanometers. As a result, it may be desired to manufacture components of system 10 from materials that are thermally stable, e.g., have a thermal expansion coefficient of less than about 10 ppm/degree centigrade at about room temperature (e.g. 25 degrees Centigrade). In some embodiments, the material of construction may have a thermal expansion coefficient of less than about 10 ppm/degree Centigrade, or less than 1 ppm/degree Centigrade. To that end, bridge supports 12, bridge 14, and/or stage support 16 may be fabricated from one or more of the following materials: silicon carbide, iron alloys available under the trade name INVAR^{®}, or name SUPER INVAR^{™}, ceramics, including but not limited to ZERODUR^{®} ceramic. Additionally table 24 may be constructed to isolate the remaining components of system 10 from vibrations in the surrounding environment. An exemplary table 24 is available from Newport Corporation of Irvine, California.

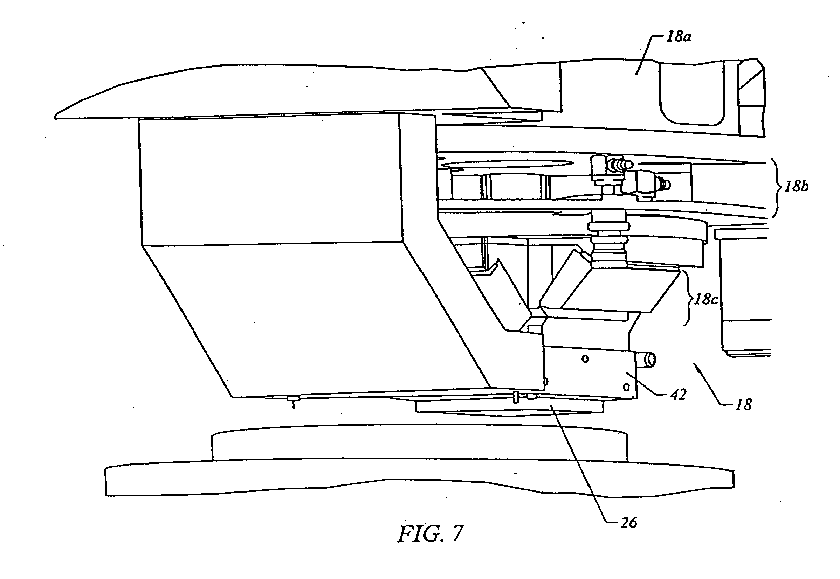

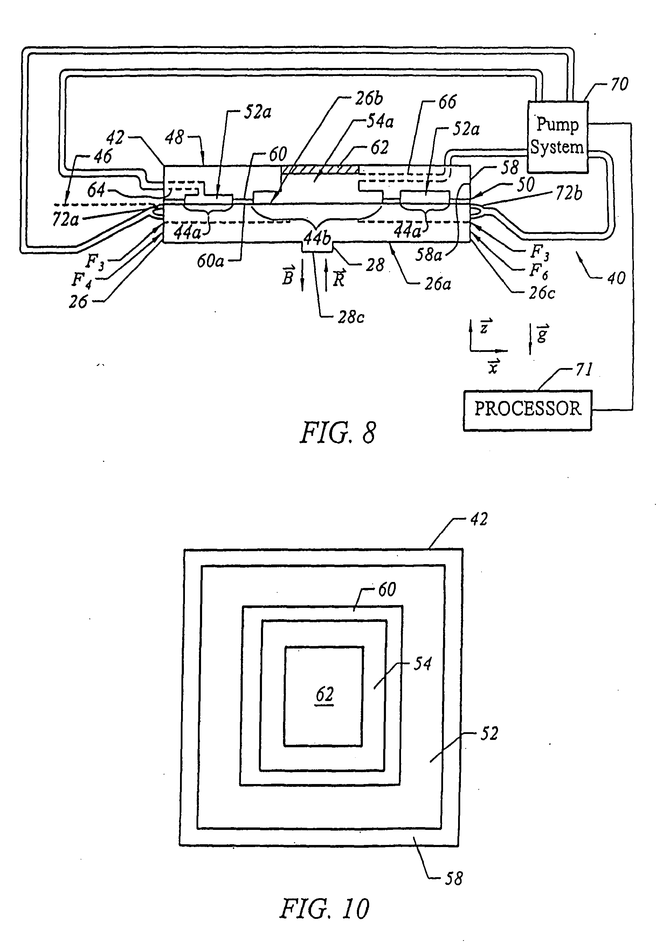

Referring to Figs. 7 and 8, substrate 26, upon which mold 28 is present, is coupled to imprint head housing 18a via a chucking system 40 that includes chuck body 42. Specifically, substrate 26 includes opposed surfaces 26a and 26b a periphery surface 26c extending therebetween. Surface 26b faces chuck system 40, and mold 28 extends from surface 26a. To ensure that fluid from beads 36, shown in Fig. 2, do not spread beyond the area of mold 28, surface 28c, shown in Fig. 8, of mold 28 is spaced-apart from surface 26a of substrate 26 a distance on the order of micron, e.g., 15 microns. A calibration system 18b is coupled to imprint head housing 18a, and chuck body 42 couples substrate 26 to calibration system 18b vis-a-vis a flexure system 18c. Calibration system 18b facilitates proper orientation alignment between substrate 26 and wafer 30, shown in Fig. 5, thereby achieving a substantially uniform gap distance ,"d", therebetween.

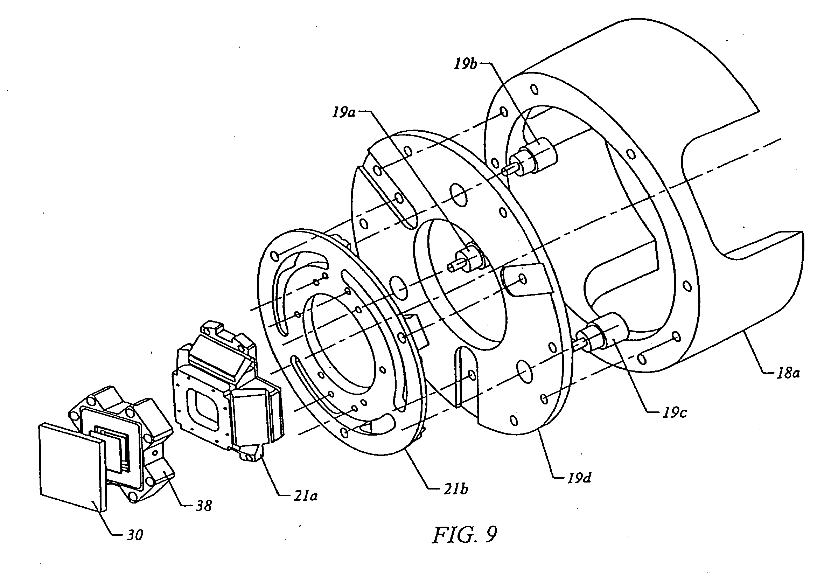

Referring to both Figs. 7 and 9, calibration system 18b includes a plurality of actuators 19a, 19b and 19c and a base plate 19d. Specifically, actuators 19a, 19b and 19c are connected between housing 18a and base plate 19d. Flexure system 18c includes flexure springs 21a and flexure ring 21b. Flexure ring 21b is coupled between base plate 19d and flexure springs 21a. Motion of actuators 19a, 19b and 19c orientates flexure ring 21b that may allow for a coarse calibration of flexure springs 21a and, therefore, chuck body 42 and substrate 26. Actuators 19a, 19b and 19c also facilitate translation of flexure ring 21b to the Z-axis. Flexure springs 21a include a plurality of linear springs that facilitate gimbal-like motion in the X-Y plane so that proper orientation alignment may be achieved between wafer 30 and substrate 26, shown in Fig. 2.

Referring to Figs. 8 and 10 chuck body 42 is adapted to retain substrate 26 upon which mold 28 is attached employing vacuum techniques. To that end, chuck body 42 includes first 46 and second 48 opposed sides. A side, or edge, surface 50 extends between first side 46 and second side 48. First side 46 includes a first recess 52 and a second recess 54, spaced-apart from first recess 52, defining first 58 and second 60 spaced-apart support regions. First support region 58 cinctures second support region 60 and the first 52 and second 54 recesses. Second support region 60 cinctures second recess 54. A portion 62 of chuck body 42 in superimposition with second recess 54 is transparent to radiation having a predetermined wavelength, such as the wavelength of the actinic radiation mentioned above. To that end, portion 62 is made from a thin layer of transparent material, such as glass. However, the material from which portion 62 is made may depend upon the wavelength of radiation produced by radiation source 22, shown in Fig. 2. Portion 62 extends from second side 48 and terminates proximate to second recess 54 and should define an area at least as large as an area of mold 28 so that mold 28 is in superimposition therewith. Formed in chuck body 42 are one or more throughways, shown as 64 and 66. One of the throughways, such as throughway 64 places first recess 52 in fluid communication with side surface 50. The remaining throughway, such as throughway 66, places second recess 54 in fluid communication with side surface 50.

It should be understood that throughway 64 may extend between second side 48 and first recess 52, as well. Similarly, throughway 66 may extend between second side 48 and second recess 54. What is desired is that throughways 64 and 66 facilitate placing recesses 52 and 54, respectively, in fluid communication with a pressure control system, such a pump system 70.

Pump system 70 may include one or more pumps to control the pressure proximate to recesses 52 and 54, independently of one another. Specifically, when mounted to chuck body 42, substrate 26 rests against first 58 and second 60 support regions, covering first 52 and second 54 recesses. First recess 52 and a portion 44a of substrate 26 in superimposition therewith define a first chamber 52a. Second recess 54 and a portion 44b of substrate 26 in superimposition therewith define a second chamber 54a. Pump system 70 operates to control a pressure in first 52a and second 54a chambers.

For example, the pressure may be established in first chamber 52a to maintain the position of substrate 26 with chuck body 42 and reduce, if not avoid, separation of substrate 26 from chuck body 42 under force of gravity, g. The pressure in second chamber 54a may differ from the pressure in first chamber 52a to reduce, *inter alia,* out of surface distortions in the pattern, defined by the features on mold 28, which occur during imprinting. Out of surface distortions may occur, for example, from an upward force R against mold 28 that occurs as a result of imprinting layer 34, shown in Fig. 2, contacting mold 28. By modulating a shape of substrate 26, shown in Fig. 8, out of surface distortions in the pattern may be attenuated, if not avoided. For example, pump system 70 may apply a positive pressure in chamber 54a to compensate for force R. This produces a pressure differential between differing regions of side 46 so that bowing of substrate 26 and, therefore, mold 28 under force R is controlled or attenuated to provide substrate 26 and, therefore mold 28, with a desired predetermined shape. Exemplary shapes that substrate 26 and mold 28 may take includes ellipsoidal, arcuate, planar, parabolic, saddle-shape and the like.

Referring to Figs. 2 and 8, imprint head 18 may include a pressure sensor 18d to detect a magnitude of force R to which mold 28 is subjected during an imprinting process. Information is produced by sensor that is transmitted to a processor 71 in data communication therewith. In response to the information obtained from sensor 18d, processor 71 may control pump system 70 to establish the pressure within chambers 52a and 54a to compensate for force R so that substrate 26 and, therefore mold 28, have a desired predetermined shape.

The pressure in chambers 52a and 54a may be established based upon *a priori* knowledge of force R from previous imprinting processes that was detected by pressure sensor 18d. As a result, the pressure in chambers 52a and 54a may be established either before or after contact is made between mold 28 and imprinting layer 34 in order to ensure that substrate 26 and, therefore, mold 28, has a desired predetermined shape. In some instances it may be desirable to pressurize chamber 54a on-the-fly, or dynamically, during imprinting process. For example, it may be advantageous to establish the pressure in chamber 54a to properly shape substrate 26, as desired, after mold 28 contacts imprinting layer 34. The positive pressure established in chamber 54a to obtain a desired predetermined shape of substrate 26 and, therefore, mold 28, may be greater than the vacuum pressure established in chamber 52a. This would cause substrate 26 to decouple from chuck body 42.

To maintain the relative position between chuck body 42 and substrate 26 during imprinting, the pressure in chamber 54a may be established dynamically after mold 28 contacts imprinting layer 34. In this manner, both force R and the vacuum pressure in chamber 52a ensures that the relative position between chuck body 42 and substrate 26 is maintained in the face of a positive pressure in chamber 54a. After mold 28 imprints the pattern in imprinting layer 34, pressure in chamber 54a may be adjusted to establish a vacuum therein. In this manner, all chambers 52a and 54a have a vacuum to facilitate separation of mold 28 from imprinting layer 34, while maintaining the relative position between chuck body 42 and substrate 26.

Coupled to substrate 26 is a means to compress the same in X and Y directions, with the understanding that the Y-direction is into the plane of Fig. 8. In the present example the means to compress includes a fluid-tight bladder system surrounding periphery surface 26c having one or more bladders, two of which are shown as 72a and 72b that extend along the Y axis, with the understanding that bladders extending along the X axis of periphery surface 26c are not shown for the sake of clarity, but are included in the present embodiment. Other devices capable of compressing substrate 26 may be employed in addition to, or in lieu of, bladder system, such as a vice or piezoelectric actuators that function as a vice. Bladders 72a and 72b are in fluid communication with pump system 70 to control the fluid pressure in bladders 72a and 72b. In this manner, bladders 72a and 72b may be used to apply forces to substrate 26 to vary the dimensions of the same and reduce in-surface distortions in the pattern recorded into imprinting layer 34, shown in Fig. 2.

In surface distortions in the pattern recorded into imprinting layer 34 may arise from, inter alia, dimensional variations of imprinting layer 34 and wafer 30. These dimensional variations, which may be due in part to thermal fluctuations, as well as, inaccuracies in previous processing steps that produce what is commonly referred to as magnification/run-out errors. The magnification/run-out errors occur when a region of wafer 30 in which the original pattern is to be recorded exceeds the area of the original pattern. Additionally, magnification/run-out errors may occur when the region of wafer 30, in which the original pattern is to be recorded, has an area smaller than the original pattern. The deleterious effects of magnification/run-out errors are exacerbated when forming multiple layers of imprinted patterns, shown as imprinting layer 124 in superimposition with patterned surface 32a, shown in Fig. 6. Proper alignment between two superimposed patterns is difficult in the face of magnification/run-out errors in both single-step full wafer imprinting and step-and-repeat imprinting processes.

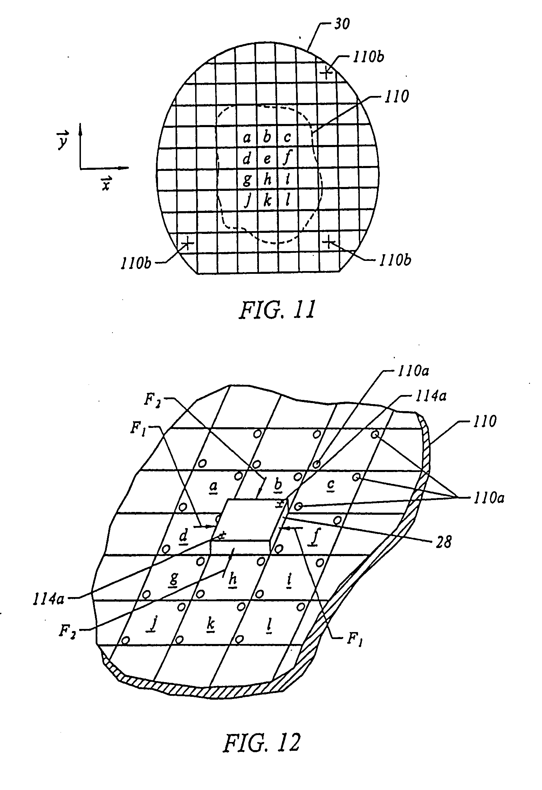

Referring to Figs. 11 and 12, a step-and-repeat process includes defining a plurality of regions, shown as, a-1, on wafer 30 in which the original pattern on mold 28 will be recorded. The original pattern on mold 28 may be coextensive with the entire surface of mold 28, or simply located to a sub-portion thereof. The present invention will be discussed with respect to the original pattern being coextensive with the surface of mold 28 that faces wafer 30, but it should be understood that substrate 26 has an area greater than each of regions a-1. Proper execution of a step-and-repeat process may include proper alignment of mold 28 with each of regions a-1. To that end, mold 28 includes alignment marks 114a, shown as a "+" sign. One or more of regions a-1 includes fiducial marks 110a. By ensuring that alignment marks 114a are properly aligned with fiducial marks 110a, proper alignment of mold 28 with one of regions a-1 in superimposition therewith is ensured. To that end, machine vision devices (not shown) may be employed to sense the relative alignment between alignment marks 114a and fiducial marks 110a. In the present example, proper alignment is indicated upon alignment marks 114a being in superimposition with fiducial marks 110a. With the introduction of magnification/run-out errors, proper alignment becomes very difficult.

However, in accordance with one embodiment of the present invention, magnification/run-out errors are reduced, if not avoided, by creating relative dimensional variations between mold 28 and wafer 30. Specifically, the temperature of wafer 30 is varied so that one of regions a-1 defines an area that is slightly less than an area of the original pattern on mold 28. Thereafter, the final compensation for magnification/run-out errors is achieved by subjecting substrate 26, shown in Fig. 8, to mechanical compression forces using bladdesr 72a and 72b, which are in turn transferred to mold 28 shown by arrows F₁ and F₂, orientated transversely to one another, shown in Fig. 12. In this manner, the area of the original pattern is made coextensive with the area of the region a-1 in superimposition therewith.

Referring to both Figs. 5 and 8, subjecting substrate 26 to compressive forces, however, modulates the shape of the same through bending action. Bending of substrate 26 may also introduce distortions in the pattern imprinted into imprinting layer 34. The pattern distortions attributable to bending of substrate 26 may be reduced, if not prevented, by positioning bladdesr 72a and 72b so that the bending of substrate 26 is controlled to occur in a desired direction. In the present example, bladdesr 72a and 72b is positioned to compress substrate 26 so as to bow in a direction parallel to, and opposite of, force R. By controlling the bending of substrate 26 in this manner, chucking system 40 may be employed to compensate for bending force, B, so as to establish mold 28 to obtain a desired predetermined, e.g., arcuate, planar and the like. Pump system 70 may be employed to pressurize chamber 54a appropriately to that end. For example, assuming bending force, B, is greater than force R, pump system 70 would be employed to evacuate chamber 54a with sufficient vacuum to counter the bending force B. Were bending force B weaker than force, R, pump system 70 would be employed to pressurize chamber 54a appropriately to maintain planarity of mold 28, or any other desired shape. The exact pressure levels may be determined with a priori knowledge of the forces R and B which then may be analyzed by a processor 71 that may be included in pump system 70 to pressurize chambers 52a and 54a to the appropriate levels. Also, the forces R and B may be sensed dynamically using known techniques, such as pressure sensor 18d and processor 71 discussed above, so that the pressure within chambers 52a and 54a may be established dynamically during operation to maintain substrate 26 with a desired shape. The magnitude of the bending force is dependent upon many factors, such as the shape of periphery surface 26c, e.g., whether periphery surface 26c extends orthogonally to first and second surface 26a and 26b or forms an oblique angle with respect thereto, as well as the location on periphery surface 26c that bladders 72a and 72b apply a force, as well as the pattern of beads 36 on surface 32, shown in Fig. 2. Means for applying a single compressive force is shown on opposing regions of periphery surface, such as bladders 72a and 72b. It should be understood that multiple compressive forces can be applied to opposing regions of periphery surface 26c, shown as forces F₃, F₄, F₅ and F₆. Forces F₃, F₄, F₅ and F₆ may have identical or differing magnitudes as required to provide substrate 26 with a desired predetermined shape. An added benefit is that the pressure in one or both chambers 52a and 54a may be established to be a positive pressure, thereby facilitating removal of substrate 26 from chuck body 42. This also may be accomplished under processor control, or manually.

Referring again to Fig. 8, when compressing substrate 26 with bladdesr 72a and 72b, relative movement between substrate 26 and support regions 58 and 60 occurs along the X and Y axes. As a result, it is desired that support regions 58 and 60 have surface regions 58a and 60a, respectively, formed thereon from a material adapted to conform to a profile of said substrate 26 and resistant to deformation along the X and Y axes. In this manner, surface regions 58a and 60a resist relative movement of substrate 26 with respect to chuck body 42 in the X and Y directions.

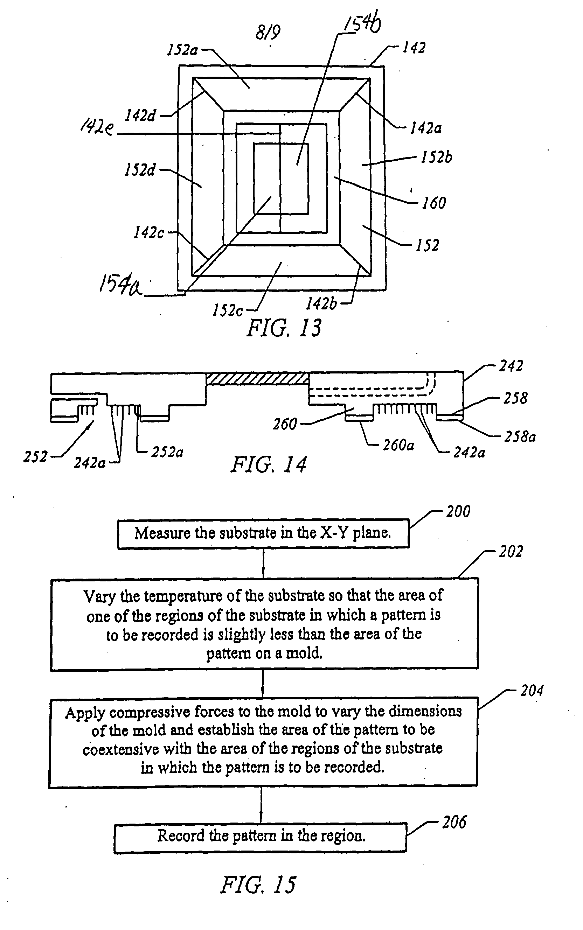

Referring to Figs. 8 and 13, in another embodiment, chuck body 142 may include one or more walls, or baffles, shown as 142a, 142b, 142c and 142d extending between first and second support regions 158 and 160. In this fashion, walls/baffles 142a, 142b, 142c and 142d segment recess 152 into a plurality of sub-regions 152a, 152b, 152c and 152d that function as sub-chambers once substrate 26 is placed in superimposition therewith. Sub-chambers 152a, 152b, 152c and 152d may be fluid-tight which would result in each have a throughway (not shown) placing the same in fluid communication with pump system 70. Alternatively, or in conjunction therewith, sub-chambers 152a, 152b, 152c and 152d may not form fluid-tight chambers once substrate 26 is placed in superimposition therewith. Rather walls 142a, 142b, 142c and 142d would be spaced apart from substrate 26 to function as a baffle for fluid transfer across the same. As a result, with the appropriate pressure level being provided by pump system 70 to recess 152, a pressure differential could be provided between sub-chambers 152a, 152b, 152c and 152d, as desired. In a similar fashion one or more baffles, shown as 142e may be positioned to extend between opposing areas of support region 160 to form sub-chambers 154a and 154b, if desired.

Referring to both Figs. 2 and 13, providing walls/baffles 142a, 142b, 142c and 142d this configuration, sub-regions 152a, 152b, 152c and 152d may be concurrently provided with differing pressure levels. As a result, the amount of force exerted on substrate 26 when being pulled-apart from imprinting layer 34 may vary across the surface of substrate 26. This allows cantilevering, or peeling-off of substrate 26 from imprinting layer 34 that reduces distortions or defects from being formed in imprinting layer 34 during separation of substrate 26 therefrom. For example, sub-chamber 152b may have a pressure established therein that is greater than the pressure associated with the remaining sub-chambers 152a, 152c and 152d. As a result, when increasing distance "d" the pulling force of the portion of substrate 26 in superimposition with sub-chambers 152a, 152c and 152d is subjected to is greater than the pulling force to which the portion of substrate 26 in superimposition with sub-chamber 152b is subjected. Thus, the rate that "d" increases for the portion of substrate 26 in superimposition with sub-chambers 152a, 152c and 152d is accelerated compared to the rate at which "d" increases for the portion of substrate 26 in superimposition with sub-chamber 152b, providing the aforementioned cantilevering effect.

In yet another embodiment, shown in Fig. 14, chuck body 242 includes a plurality of pins 242a projecting from a nadir surface 252a of out recess 252. Pins 242a provide mechanical support for the wafer (not shown] retained on chuck body 242 via vacuum. This enables support regions 258 and 260 to have surface regions 258a and 260a, respectively, formed from material that is fully compliant with the surface (not shown) of the wafer (not shown) resting against support regions 258 and 260. In this manner, surface regions 258a and 260a provide a fluid-tight seal with the wafer (not shown) in the presence of extreme surface variation, e.g., when particulate matter is present between the surface (not shown) of the wafer (not shown) and the surface regions 258a and 260a. Mechanical support of the wafer (not shown) in the Z direction need not be provided by surface regions 258a and 260a. Pins 242a provide this support. To that end, pins 242a are typically rigid posts having a circular cross-section.

Referring to Figs. 11, 12 and 15, in operation, an accurate measurement of wafer 30 in an X-Y plane is undertaken at step 200. This may be achieved by sensing gross alignment fiducials 110b present on wafer 30 using machine vision devices (not shown) and known signal processing techniques. At step 202, the temperature of wafer 30 may be varied, i.e., raised or lowered, so that the area of one of regions a-1 is slightly less than an area of the original pattern on mold 28. The temperature variations may be achieved using a temperature controlled chuck or pedestal (not shown) against which wafer 30 rests. The area of each of regions a-1 can be determined by measurement of a change in distance between two collinear gross alignment fiducials 110b.

Specifically, a change in the distance between two gross alignment fiducials 110b collinear along one of the X or Y axes is determined. Thereafter, this change in distance is divided by a number of adjacent regions a1 on the wafer 30 along the X-axis. This provides the dimensional change of the areas of regions a-1 attributable to dimensional changes in wafer 30 along the X-axis. If necessary the same measurement may be made to determine the change in area of regions a-1 due to dimensional changes of wafer 30 along the Y-axis. However, it may also be assumed that the dimensional changes in wafer 30 may be uniform in the two orthogonal axes, X and Y.

At step 204, compressive forces, F₁ and F₂, are applied to mold 28 to establish the area of the original pattern to be coextensive with the area of one of the regions a-1 in superimposition with the pattern. This may be achieved in real-time employing machine vision devices (not shown) and known signal processing techniques, to determine when two or more of alignment marks 114a are aligned with two or more of fiducial marks 110a. At step 206, after proper alignment is achieved and magnification/run-out errors are reduced, if not vitiated, the original pattern is recorded in the region a-1 that is in superimposition with mold 28, forming the recorded pattern. It is not necessary that compression forces F₁ and F₂ have the same magnitude, as the dimensional variations in either wafer 30 or mold 28 may. not be uniform in all directions. Further, the magnification/run-out errors may not be identical in both X-Y directions. As a result, compression forces, F₁ and F₂ may differ to compensate for these anomalies. Furthermore, to ensure greater reduction in magnification/run-out errors, the dimensional variation in mold 28 may be undertaken after mold 28 contacts imprinting layer 124, shown in Fig. 6. However, this is not necessary.

Referring again to Figs. 6, 11 and 12, the alignment of mold 28 with regions a-1 in superimposition therewith may occur with mold 28 being spaced-apart from imprinting layer 124. Were it found that the magnification/run-out errors were constant over the entire wafer 30, then the magnitude of forces F₁ and F₂ could be maintained for each region a-1 in which the original pattern is recorded. However, were it determined that the magnification/run-out errors differed for one or more regions a-1, steps 202 and 204, shown in Fig. 15, would then be undertaken for each region a-1 in which the original pattern is recorded. It should be noted that there are limits to the relative dimensional changes that may occur between wafer 30 and mold 28. For example, the area of the regions a-1 should be of appropriate dimensions to enable pattern on mold 28 to define an area coextensive therewith when mold 28 is subject to compression forces F₁ and F₂, without compromising the structural integrity of mold 28.

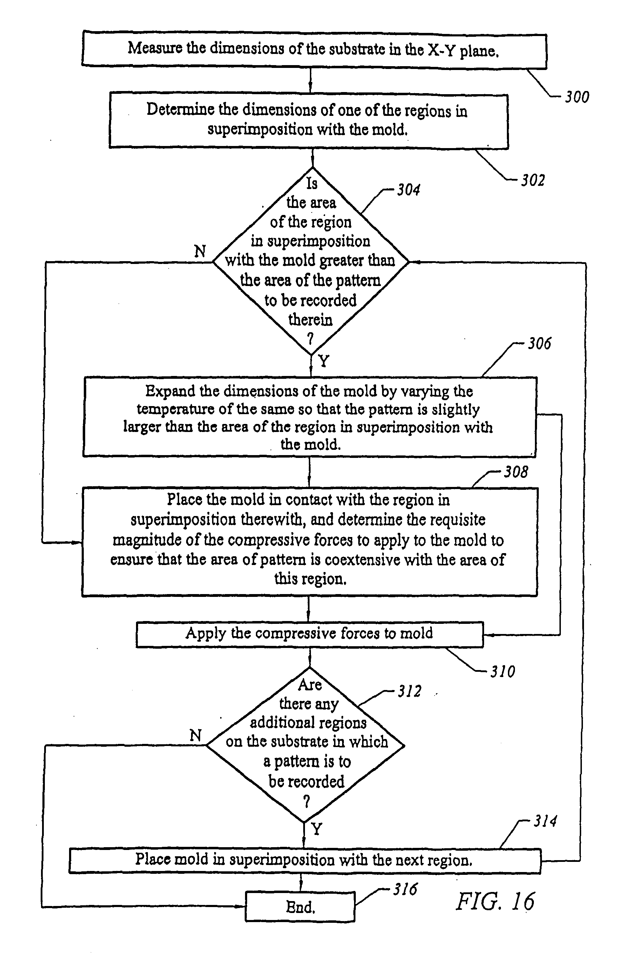

Referring to Figs. 5 and 16, in accordance with another embodiment of the present invention, accurate measurement of wafer 30 in an X-Y plane is undertaken at step 300. At step 302, the dimensions of one of regions a-1 in superimposition with mold 28 is determined. At step 304 it is determined whether the area of one of regions a-1 in superimposition with mold 28 is larger than the area of the pattern on mold 28. If this is the case, the process proceeds to step 306, otherwise the process proceeds to step 308. At step 308, mold 28 is placed in contact with the region a-1 in superimposition therewith, and the requisite magnitude of compressive forces F₁ and F₂ is determined to apply to mold 28 to ensure that the area of pattern is coextensive with the area of this region a-1. At step 310, compressive forces F₁ and F₂ are applied to mold 28. Thereafter, mold 28 is spaced-apart from the region a-1 in superimposition with mold 28 and the process proceeds to step 312 where it is determined whether there remain any regions a-1 on wafer 30 in which to record the original pattern. If there are, the process proceeds to step 314 wherein mold is placed in superimposition with the next region and the process proceeds to step 304. Otherwise, the process ends at step 316.

Were it determined at step 304 that the region a-1 in superimposition with mold 28 had an area greater than the area of the pattern, then the process proceeds to step 306 wherein the temperature of mold 28 is varied to cause expansion of the same. In the present embodiment, mold 28 is heated at step 306 so that the pattern is slightly larger than the area of region a-1 in superimposition therewith. Then the process continues at step 310.

The embodiments of the present invention described above are exemplary. Many changes and modifications may be made to the disclosure recited above, while remaining within the scope of the invention. For example, by pressurizing all chambers formed by the chuck body-substrate combination with positive fluid pressure, the substrate may be quickly released from the chuck body. Further, many of the embodiments discussed above may be implemented in existing imprint lithography processes that do not employ formation of an imprinting layer by deposition of beads of polymerizable material. Exemplary processes in which differing embodiments of the present invention may be employed include a hot embossing process disclosed in United States patent number 5,772,905, which is incorporated by reference in its entirety herein. Additionally, many of the embodiments of the present invention may be employed using a laser assisted direct imprinting (LADI) process of the type described by Chou et al. in Ultrafast and Direct Imprint of Nanostructures in Silicon, Nature, Col. 417, pp. 835-837, June 2002. Therefore, the scope of the invention should be determined not with reference to the above description, but instead should be determined with reference to the appended claims along with their full scope of equivalents.

## Claims

1. A chucking system to hold a substrate, said chucking system comprising:
a chuck body (42; 142; 242) having first and second opposed sides (46, 48) with an edge surface (50) extending therebetween, said first side (46) including first and second spaced-apart recesses (52, 54; 152, 154a, 154b; 252, 254) defining first and second spaced-apart support regions (58, 60; 158, 160; 258, 260), with said first support region (58; 158; 258) cincturing said second support region (60; 160; 260) and said first and second recesses (52, 54; 152, 154a, 154b; 252, 254), and said second support region (60; 160; 260) cincturing said second recess (54; 154a, 154b; 254), with a portion (62) of said body (42; 142; 242) in superimposition with said second recess (54; 154a, 154b; 254) being transparent to radiation having a predetermined wavelength, said portion (62) extending from said second side (48) and terminating proximate to said second recess (54;154a, 154b; 254), said second side (48) and said edge surface (50) defining exterior surfaces,
with said body (42; 142;152) including:
a throughway (64) extending through said body placing one of said first and second recesses (52, 54; 152, 154a, 154b; 252, 254) in fluid communication with one of said exterior surfaces (48, 50);
an additional throughway (66), said throughway (64) and said additional throughway (66) placing each of said first and second recesses (52, 54; 152, 154a, 154b; 252, 254) in fluid communication with one of said exterior surfaces (48, 50); and
a pressure control system (70) in fluid communication with both said throughway and said additional throughway (6, 66), with said substrate (26) resting against said first and
second support regions (58, 60; 158, 160; 258, 260), covering said first and second recesses (52, 54; 152, 154a, 154b; 252, 254), with said first recess (52; 152; 252) and
the portion (44a) of said substrate (26) in superimposition therewith defining a first chamber (52a) and said second recess (54) and the portion (44b) of said substrate (26) in superimposition therewith defining a second chamber (54a),
**characterized in that** said pressure control system is configured to create a pressure differential between said first and second chambers (52a, 54a) modulating a shape of the substrate (26).

2. The chucking system as recited in claim 1 wherein each of said first and second support regions (58, 60; 158, 160; 258, 260) has a support surface (58a, 60a; 258a, 260a) associated therewith, facing away from said second surface, with said support surface being formed from a material adapted to conform to a profile of said substrate (26).

3. The chucking system as recited in claim 1 wherein said first recess (252), includes a plurality of spaced-apart pins (242a) extending therefrom.

4. The chucking system as recited in claim 1 wherein each of said first and second support regions (58, 60; 158, 160; 258, 260) has a support surface (58a, 60a; 258a, 260a) associated therewith, facing away from said second surface, with said support surface being formed from a material compliant in a first direction extending between said first and second opposed sides (46, 48) to conform to a profile of said substrate (26) while being resistant to movement in a direction transverse to said first direction.

5. The chucking system as recited in claim 1 further including a wall (142a, 142b, 142c, 142d) disposed within said first recess (152), extending between said first and second support regions to segment said first recess (152) into a plurality of sub-chambers (152a, 152b, 152c, 152d).

6. The chucking system as recited in claim 1 wherein said first support region (58; 158; 258) is concentric about said second support region (60; 160; 260) and has a shape that is selected from a set of shapes consisting of annular, polygonal and circular.

7. The chucking system as recited in claim 1 further including a means coupled to bend said substrate so as to curve a shape of said first and second opposed sides.

8. A method for modulating shapes of a substrate, having first and second opposed surfaces (26a, 26b), said method comprising:
creating a pressure differential between differing regions of said first opposed surface to attenuate structural distortions in said second opposed surface.
wherein the step of creating a pressure differential includes:
providing a chuck body (42; 142; 242) having first and second opposed sides (46, 48) with an edge surface (50) extending therebetween, said first side (46) including first and second spaced-apart recesses (52, 54; 152, 154a, 154b; 252, 254) defining first and second spaced apart support regions (58; 158; 258),
providing a pressure control system (70) wherein a first throughway (64) places the first recess in fluid communication with the pressure control system and a second throughway (66) places the second recess in fluid communication with the pressure control system,
resting said substrate (26) against said first and second support regions (58; 158; 258) and covering said first and second recesses (52, 54; 152, 154a, 154b; 252, 254), with said first recess (52; 152; 252) and the portion (44a) of said substrate (26) in superimposition therewith defining a first chamber (52a) and said second recess (54) and the portion (44b) of said substrate (26) in superimposition therewith defining a second chamber (54b),
said pressure differential being created by establishing differing pressure levels within said first and second chambers (52a, 54a).

9. The method as recited in claim 8 wherein creating further includes subjecting a first subset of said regions to a pulling force and subjecting a second subset of said regions to a pushing force to establish a sub-portion of said second opposed surface to have a desired predetermined shape.

10. The method as recited in claim 8 wherein creating further includes subjecting a first subset of said regions to a pulling force that is substantially greater than a pulling force associated with the remaining regions of said differing regions, with said first subset being contiguous and positioned proximate to a periphery of said substrate (26).

11. The method as recited in claim 8 further including applying compressive forces to said substrate (26) to vary dimensions thereof that induce a bending action, with creating further including creating a pulling force to attenuate said bending action and maintain a desired predetermined shape of said portion of said second surface.

12. The method as recited in claim 8 wherein creating further includes establishing a first of said differing regions to cincture a second of said differing regions, with said first region having a pulling force applied thereto and said second region having a pushing force present thereon.

13. The method as recited in claim8 wherein creating a pressure differential further includes attenuating structural distortions in said second opposed surface by varying said pressure differential to compensate for external pressures bearing on said second surface.

14. The method as recited in claim 8 further including providing said second surface with a mold (28) having a pattern thereon and a wafer (30) having an imprinting layer (34) disposed thereon facing said pattern and contacting said imprinting layer (34) with said mold (28), wherein said step of creating a pressure differential includes establishing a positive pressure within said second chamber (54a) after contacting said imprinting layer (34) with said mold (28).

15. The method as recited in claim 14 further including separating said mold from said imprinting layer and evacuating said second chamber before separating said mold (28) from said imprinting layer (34).

## Patentansprüche

1. Spannsystem zum Halten eines Substrats, das Spannsystem umfassend:
einen Spannvorrichtungskörper (42; 142; 242) mit ersten und zweiten gegenüberliegenden Seiten (46, 48) mit einer sich dazwischen erstreckenden Kantenoberfläche (50), wobei die erste Seite (46) erste und
zweite beabstandete Aussparungen (52, 54; 152, 154a, 154b; 252, 254) beinhaltet, die erste und zweite beabstandete Unterstützungsbereiche (58, 60; 158, 160; 258, 260) definieren, wobei der erste Unterstützungsbereich (58; 158; 258) den zweiten Unterstützungsbereich (60; 160; 260) und die ersten und zweiten Aussparungen (52, 54; 152, 154a, 154b; 252, 254) umgürtet, und wobei der zweite Unterstützungsbereich (60; 160; 260) die zweite Aussparung (54; 154a, 154b; 254) umgürtet, wobei ein Teil (62) des Körpers (42; 142; 242) in Übereinanderlagerung mit der zweiten Aussparung (54; 154a, 154b; 254) transparent für Strahlung mit einer vorgegebenen Wellenlänge ist, und wobei der Teil (62) sich von der zweiten Seite (48) aus erstreckt und nahe der zweiten Aussparung (54; 154a, 154b; 254) endet, und wobei die zweite Seite (48) und die Kantenoberfläche (50) äußere Oberflächen definieren,
wobei der Körper (42; 142, 152) beinhaltet:
einen Durchgang (64), der sich durch den Körper erstreckt und der eine der ersten und zweiten Aussparungen (52, 54; 152, 154a, 154b; 252, 254) in Fluidverbindung mit einer der äußeren Oberflächen (48, 50) anordnet;
einen zusätzlichen Durchgang (66), wobei der Durchgang (64) und der zusätzliche Durchgang (66) jede der ersten und zweiten Aussparungen (52, 54; 152, 154a, 154b; 252, 254) in Fluidverbindung mit einer der äußeren Oberflächen (48, 50) anordnet; und
ein Drucksteuerungssystem (70) in Fluidverbindung mit sowohl dem Durchgang als auch dem zusätzlichen Durchgang (66), wobei das Substrat (26) an den ersten und zweiten Unterstützungsbereichen (58, 60; 158, 160; 258, 260) anliegt, und die ersten und zweiten Aussparungen (52, 54; 152, 154a, 154b; 252, 254) abdeckt, wobei die erste Aussparung (52; 152; 252) und der Teil (44a) des Substrats (26) in Übereinanderlagerung damit eine erste Kammer (52a) definieren und die zweite Aussparung (54) und der Teil (44b) des Substrats (26) in Übereinanderlagerung damit eine zweite Kammer (54a) definieren,
**dadurch gekennzeichnet, dass** das Drucksteuerungssystem konfiguriert ist, um eine Druckdifferenz zwischen den ersten und zweiten Kammern (52a, 54a) zum Modulieren einer Form des Substrats (26) zu erzeugen.

2. Spannsystem nach Anspruch 1, wobei jeder der ersten und zweiten Unterstützungsbereiche (58, 60; 158, 160; 258, 260) eine zugehörige Unterstützungsoberfläche (58a, 60a; 258a, 260a) hat, die der zweiten Oberfläche abgewandt ist, wobei die Unterstützungsoberfläche aus einem Material gebildet ist, dass angepasst ist, um einem Profil des Substrats (26) zu entsprechen.

3. Spannsystem nach Anspruch 1, wobei die erste Aussparung (252) eine Mehrzahl von beabstandeten Stiften (242a) beinhaltet, die sich daraus erstrecken.

4. Spannsystem nach Anspruch 1, wobei jede der ersten und zweiten Unterstützungsregionen (58, 60; 158, 160; 258, 260) eine zugehörige Unterstützungsoberfläche (58a, 60a; 258a, 260a) hat, die von der zweiten Oberfläche abgewandt ist, wobei die Unterstützungsoberfläche aus einem Material gebildet ist, dass in einer ersten Richtung sich erstreckend zwischen den ersten und zweiten gegenüberliegenden Seiten (46, 48) nachgiebig ist, um einem Profil des Substrats (26) zu entsprechen, während es einer Bewegung in einer Richtung transversal zu der ersten Richtung widersteht.

5. Spannsystem nach Anspruch 1, weiter beinhaltend eine Wand (142a, 142b, 142c, 142d) angeordnet innerhalb der ersten Aussparung (152) sich erstreckend zwischen den ersten und zweiten Unterstützungsbereichen, um die erste Aussparung (152) in eine Mehrzahl von Unterkammern (152a, 152b, 152c, 152d) zu segmentieren.

6. Spannsystem nach Anspruch 1, wobei die erste Unterstützungsregion (58; 158; 258) um die zweite Unterstützungsregion (60; 160; 260) konzentrisch ist, und eine Form hat, die ausgewählt ist aus einer Menge von Formen bestehend aus ringförmig, polygonal, und kreisförmig.

7. Spannsystem nach Anspruch 1, weiter beinhaltend ein Mittel gekoppelt um das Substrat zu biegen, um eine Form der ersten und zweiten gegenüberliegenden Seiten zu krümmen.

8. Verfahren zum Modulieren von Formen eines Substrats, das erste und zweite gegenüberliegende Oberflächen (26a, 26b) hat, das Verfahren umfassend:
Erzeugen einer Druckdifferenz zwischen unterschiedlichen Bereichen der ersten gegenüberliegenden Oberfläche, um strukturelle Verzerrungen in der zweiten gegenüberliegenden Oberfläche abzumildern,
wobei der Schritt des Erzeugens einer Druckdifferenz beinhaltet:
Bereitstellen eines Spannvorrichtungskörpers (42; 142; 242) mit ersten und zweiten gegenüberliegenden Seiten (46, 48) mit einer sich dazwischen erstreckenden Kantenoberfläche (50), wobei die erste Seite (46) erste und zweite beabstandete Aussparungen (52, 54; 152, 154a, 154b; 252, 254) beinhaltet, die erste und zweite beabstandete Unterstützungsbereiche (58; 158; 258) definieren, Bereitstellen eines Drucksteuerungssystems (70),
wobei ein erster Durchgang (64) die erste Aussparung in Fluidverbindung mit dem Drucksteuerungssystem anordnet und ein zweiter Durchgang (66) die zweite Aussparung in Fluidverbindung mit dem Drucksteuerungssystem anordnet,
Anlegen des Substrats (26) an die ersten und zweiten Unterstützungsbereiche (58; 158; 258) und Abdecken der ersten und zweiten Aussparungen (52, 54; 152, 154a, 154b; 252, 254), wobei die erste Aussparung (52; 152; 252) und der Teil (44a) des Substrats (26) in Übereinanderlagerung damit eine erste Kammer (52a) definieren und
wobei die zweite Aussparung (54) und der Teil (44b) des Substrats (26) in Übereinanderlagerung damit eine zweite Kammer (54b) definieren,
wobei die Druckdifferenz durch die Einrichtung unterschiedlicher Druckniveaus innerhalb der ersten und zweiten Kammern (52a, 54a) erzeugt wird.

9. Verfahren nach Anspruch 8, wobei das Erzeugen weiter beinhaltet Aussetzen einer ersten Untermenge der Bereiche einer Zugkraft und Aussetzen einer zweiten Untermenge der Bereiche einer Druckkraft um einzurichten dass ein Unter-Teil der zweiten gegenüberliegenden Oberfläche eine gewünschte vorbestimmte Form hat.

10. Verfahren nach Anspruch 8, wobei das Erzeugen weiter beinhaltet Aussetzen einer ersten Untermenge der Bereiche einer Zugkraft die im Wesentlichen größer ist als eine Zugkraft zugehörig zu den restlichen Bereichen der unterschiedlichen Bereiche, wobei die erste Untermenge zusammenhängend ist und nahe der Peripherie des Substrats (26) positioniert ist.

11. Verfahren nach Anspruch 8, weiter beinhaltend Aufbringen zusammenpressender Kräfte auf den Träger (26), um dessen Abmessungen zu variieren, die eine biegende Aktion induzieren, wobei das Erzeugen weiter beinhaltet das Erzeugen einer Zugkraft um die biegende Aktion abzumildern und eine gewünschte vorbestimmte Form des Teils der zweiten Oberfläche aufrecht zu erhalten.

12. Verfahren nach Anspruch 8, wobei das Erzeugen weiter beinhaltet Errichtung eines ersten der unterschiedlichen Bereiche um einen zweiten der unterschiedlichen Bereiche zu umgürten, wobei der erste Bereich eine Zugkraft aufgebracht bekommt und der zweite Bereich eine Druckkraft erfährt.

13. Verfahren nach Anspruch 8, wobei das Erzeugen einer Druckdifferenz weiter beinhaltet Abmildern struktureller Verzerrungen in der zweiten gegenüberliegenden Oberfläche durch Variieren der Druckdifferenz um externe Drücke aufgebracht auf die zweite Oberfläche zu kompensieren.

14. Verfahren nach Anspruch 8, weiter beinhaltend Versehen der zweiten Oberfläche mit einem Formkörper (28), der ein Muster darauf aufweist, und einen Wafer (30), der eine Prägungsschicht (34) angeordnet darauf aufweist, die dem Muster zugewandt ist, und Kontaktieren der Prägungsschicht (34) mit dem Formkörper (28), wobei der Schritt des Erzeugens einer Druckdifferenz beinhaltet Errichten eines positiven Drucks innerhalb der ersten Kammer (54a) nach dem Kontaktieren der Prägungsschicht (34) mit dem Formkörper (28).

15. Verfahren nach Anspruch 14, weiter beinhaltend Separieren des Formkörpers von der Prägungsschicht und Evakuieren der zweiten Kammer vor dem Separieren des Formkörpers (28) von der Prägungsschicht (34).

## Revendications

1. Système de mandrin pour supporter un substrat, ledit système de mandrin comprenant :
un corps de mandrin (42 ; 142 ; 242) comportant un premier et un second côtés opposés (46, 48) avec une surface de bord (50) s'étendant entre ceux-ci, ledit premier côté (46) comprenant un premier et un second encastrements espacés (52, 54 ; 152, 154a, 154b ; 252, 254) définissant une première et une seconde régions de support espacées (58, 60 ; 158, 160 ; 258, 260), ladite première région de support (58 ; 158 ; 258) entourant ladite seconde région de support (60 ; 160 ; 260) et lesdits premier et
second encastrements (52, 54 ; 152, 154a, 154b ; 252, 254), et ladite seconde région de support (60 ; 160 ; 260) entourant ledit second encastrement (54 ; 154a, 154b ; 254), une partie (62) dudit corps (42 ; 142 ; 242) en superposition avec ledit second encastrement (54 ; 154a, 154b ; 254) étant transparente au rayonnement ayant une longueur d'onde prédéterminée, ladite partie (62) s'étendant depuis ledit second côté (48) et se terminant près dudit second encastrement (54 ; 154a, 154b ; 254), ledit second côté (48) et ladite surface de bord (50) définissant des surfaces extérieures, ledit corps (42 ; 142 ; 152) comprenant :
un passage traversant (64) s'étendant à travers ledit corps plaçant un desdits premier et second encastrements (52, 54 ; 152, 154a, 154b ; 252, 254) en communication fluide avec l'une desdites surfaces extérieures (48, 50) ;
un passage traversant supplémentaire (66), ledit passage traversant (64) et ledit passage traversant supplémentaire (66) plaçant chacun desdits premier et second encastrements (52, 54 ; 152, 154a, 154b ; 252, 254) en communication fluide avec l'une desdites surfaces extérieures (48, 50) ; et
un système de commande de pression (70) en communication fluide avec ledit passage traversant et ledit passage traversant supplémentaire (66), ledit substrat (26) reposant contre lesdites première et seconde régions de support (58, 60 ; 158, 160 ; 258, 260), couvrant lesdits premier et second encastrements (52, 54 ; 152, 154a, 154b ; 252, 254), ledit premier encastrement (52 ; 152 ; 252) et la partie (44a) dudit substrat (26) en superposition avec celui-ci définissant une première chambre (52a) et ledit second encastrement (54) et la partie (44b) dudit substrat (26) en superposition avec celui-ci définissant une seconde chambre (54a),
**caractérisé en ce que** ledit système de commande de pression est configuré pour créer un différentiel de pression entre lesdites première et seconde chambres (52a, 54a) modulant une forme du substrat (26).

2. Système de mandrin selon la revendication 1, dans lequel chacune desdites première et seconde régions de support (58, 60 ; 158, 160 ; 258, 260) comporte une surface de support (58a, 60a ; 258a, 260a) associée avec celui-ci, orientée loin de ladite seconde surface, ladite surface de support étant formée d'un matériau adapté pour se conformer à un profil dudit substrat (26).

3. Système de mandrin selon la revendication 1, dans lequel ledit premier encastrement (252) comprend une pluralité d'axes espacés (242a) s'étendant depuis celui-ci.

4. Système de mandrin selon la revendication 1, dans lequel chacune desdites première et seconde régions de support (58, 60 ; 158, 160 ; 258, 260) comporte une surface de support (58a, 60a ; 258a, 260a) associée à celui-ci, orientée loin de ladite seconde surface, ladite surface de support étant formée d'un matériau conforme dans une première direction s'étendant entre lesdits premier et second côtés opposés (46, 48) pour se conformer à un profil dudit substrat (26) tout en étant résistante au mouvement dans une direction transversale à ladite première direction.

5. Système de mandrin selon la revendication 1, comprenant également une paroi (142a, 142b, 142c, 142d) disposée à l'intérieur dudit premier encastrement (152), s'étendant entre lesdites première et seconde régions de support pour segmenter ledit premier encastrement (152) en une pluralité de chambres secondaires (152a, 152b, 152c, 152d).

6. Système de mandrin selon la revendication 1, dans lequel ladite première région de support (58 ; 158 ; 258) est concentrique autour de ladite seconde région de support (60 ; 160 ; 260) et a une forme sélectionnée parmi un ensemble de formes composées de formes annulaire, polygonale et circulaire.

7. Système de mandrin selon la revendication 1, comprenant également un moyen couplé pour courber ledit substrat de façon à incurver une forme desdits premier et second côtés opposés.

8. Procédé pour moduler les formes d'un substrat, comportant une première et une seconde surface opposée (26a, 26b), ledit procédé comprenant :
la création d'un différentiel de pression entre différentes régions de ladite première surface opposée pour atténuer les déformations structurelles dans ladite seconde surface opposée,
dans laquelle l'étape de création d'un différentiel de pression comprend :
la fourniture d'un corps de mandrin (42 ; 142 ; 242) comportant un premier et un second côtés opposés (46, 48) avec une surface de bord (50) s'étendant entre ceux-ci, ledit premier côté (46) comprenant un premier et un second encastrements espacés (52, 54 ; 152, 154a, 154b ; 252, 254) définissant une première et une seconde régions de support espacées (58 ; 158 ; 258),
la fourniture d'un système de commande de pression (70) dans lequel un premier passage traversant (64) place le premier encastrement en communication fluide avec le système de commande de pression et un second passage traversant (66) place le second encastrement en communication fluide avec le système de commande de pression,
le repos dudit substrat (26) contre lesdites première et seconde régions de support (58 ; 158 ; 258) et couvrant lesdits premier et second encastrements (52, 54 ; 152, 154a, 154b ; 252, 254), ledit premier encastrement (52 ; 152 ; 252) et la partie (44a) dudit substrat (26) en superposition avec celui-ci définissant une première chambre (52a) et ledit second encastrement (54) et la partie (44b) dudit substrat (26) en superposition avec celui-ci définissant une seconde chambre (54b),
ledit différentiel de pression étant créé en établissant des niveaux de pression différents à l'intérieur desdites première et seconde chambres (52a, 54a).

9. Procédé selon la revendication 8, dans lequel la création comprend également la soumission d'un premier sous-ensemble desdites régions à une force de traction et la soumission d'un second sous-ensemble desdites régions à une force de poussée pour établir une partie secondaire de ladite seconde surface opposée pour avoir une forme prédéterminée désirée.

10. Procédé selon la revendication 8, dans lequel la création comprend également la soumission d'un premier sous-ensemble desdites régions à une force de traction sensiblement supérieure à une force de traction associée aux régions restantes desdites régions différentes, ledit premier sous-ensemble étant contigu et positionné près d'une périphérie dudit substrat (26).

11. Procédé selon la revendication 8, comprenant également l'application de forces compressives audit substrat (26) pour faire varier les dimensions de celui-ci induisant une action de courbure, la création comprenant également la création d'une force de traction pour atténuer ladite action de courbure et maintenir une forme prédéterminée désirée de ladite partie de ladite seconde surface.

12. Procédé selon la revendication 8, dans lequel la création comprend également l'établissement d'une première desdites régions différentes pour entourer une seconde desdites régions différentes, ladite première région ayant une force de traction appliquée à celle-ci et ladite seconde région ayant une force de poussée présente sur celle-ci.

13. Procédé selon la revendication 8, dans lequel la création d'un différentiel de pression comprend également l'atténuation des déformations structurelles dans ladite seconde surface opposée en faisant varier ledit différentiel de pression pour compenser les pressions externes appuyant sur ladite seconde surface.

14. Procédé selon la revendication 8, comprenant également la fourniture à ladite seconde surface d'un moule (28) comportant un motif sur celle-ci et une tranche (30) comportant une couche d'impression (34) disposée sur celle orientée face audit motif et en contact avec ladite couche d'impression (34) avec ledit moule (28), dans lequel ladite étape de création d'un différentiel de pression comprend l'établissement d'une pression positive à l'intérieur de ladite seconde chambre (54a) après le contact de ladite couche d'impression (34) avec ledit moule (28).

15. Procédé selon la revendication 14, comprenant également la séparation dudit moule de ladite couche d'impression et l'évacuation de ladite seconde chambre avant la séparation dudit moule (28) de ladite couche d'impression (34).
